# EUROPEAN PATENT APPLICATION

(11) **EP 4 503 424 A1**
(43) Date of publication of application: **05.02.2025**
(21) Application number: 24188993.0
(22) Date of filing: 16.07.2024
(51) Int. Cl.: H02M 7/5387, H02M 1/44, H02M 7/00, H01G 4/32, H01G 4/38, H01G 11/78, H02G 5/00, H05K 7/14

(54) **CAPACITOR ASSEMBLY FOR INVERTER FOR ELECTRIC VEHICLE**

(30) Priority: 31.07.2023 US 202363516642 P; 08.07.2024 US 202418765808
(71) Applicant: BorgWarner US Technologies LLC, Wilmington, DE 19801 (US)
(72) Inventor: UGARE, Chetan, Nuremberg (DE); PRINZ, Catherine, Erlangen (DE); APELSMEIER, Andreas, Pollenfeld (DE); BERINDAN, Stefan, Nürnberg (DE)
(74) Representative: Office Freylinger

(57) **Abstract**

A system may include a capacitor assembly, the capacitor assembly including: a planar busbar, the planar busbar including a first direct current (DC) busbar and a second DC busbar, one or more first capacitors on a first side of the planar busbar, the one or more first capacitors including a first bobbin with a positive end facing a first direction with respect to the planar busbar; and one or more second capacitors on the first side of the planar busbar, the one or more second capacitors including a second bobbin with a positive end facing a second direction with respect to the planar busbar, wherein the one or more first capacitors are alternately arranged with the one or more second capacitors with respect to the planar busbar.

## Description

### TECHNICAL FIELD

Various embodiments of the present disclosure relate generally to a capacitor assembly, and, more particularly, to a bulk capacitor assembly for a power module for an inverter for an electric vehicle.

### BACKGROUND

For a traction inverter, a power module is considered to be an important component of a power conversion system. The efficiency of the system may be proportional to the switching losses occurring in the power module. However, the commutation cell inductance of a power conversion system may prevent mitigating switching losses.

The present disclosure is directed to overcoming one or more of these above-referenced challenges.

### SUMMARY OF THE DISCLOSURE

In some aspects, the techniques described herein relate to a system including: an inverter to convert DC power from a battery to AC power to drive a motor, wherein the inverter includes: a capacitor assembly, the capacitor assembly including: a planar busbar, the planar busbar including a first direct current (DC) busbar and a second DC busbar; one or more first capacitors on a first side of the planar busbar, the one or more first capacitors including a first bobbin with a positive end facing a first direction with respect to the planar busbar; and one or more second capacitors on the first side of the planar busbar, the one or more second capacitors including a second bobbin with a positive end facing a second direction with respect to the planar busbar, wherein the one or more first capacitors are alternately arranged with the one or more second capacitors with respect to the planar busbar.

In some aspects, the techniques described herein relate to a system, wherein the first DC busbar is positive and the second DC busbar is negative.

In some aspects, the techniques described herein relate to a system, wherein the one or more first capacitors and the one or more second capacitors are alternately arranged in a single row.

In some aspects, the techniques described herein relate to a system, wherein the one or more first capacitors and the one or more second capacitors are alternately arranged in each row of two or more rows, so that each of the two or more rows includes a same arrangement of the one or more first capacitors and the one or more second capacitors.

In some aspects, the techniques described herein relate to a system, wherein the first DC busbar includes an inner surface and an outer surface; wherein the second DC busbar includes an inner surface and an outer surface, and wherein the inner surface of the first DC busbar faces the inner surface of the second DC busbar so that at least a portion of the first DC busbar overlaps the second DC busbar.

In some aspects, the techniques described herein relate to a system, wherein the first DC busbar further includes: a connection opening for the one or more first capacitors or the one or more second capacitors, and a cover to cover the connection opening.

In some aspects, the techniques described herein relate to a system, wherein the first bobbin and the second bobbin are arranged in either a horizontal direction or a vertical direction.

In some aspects, the techniques described herein relate to a system, wherein the one or more first capacitors being alternately arranged with the one or more second capacitors reduces inductance relative to capacitors that are not alternately arranged.

In some aspects, the techniques described herein relate to a system, wherein the one or more first capacitors include three first capacitors, and wherein the one or more second capacitors include three second capacitors.

In some aspects, the techniques described herein relate to a system, wherein the first direction and the second direction are substantially opposite.

In some aspects, the techniques described herein relate to a system, wherein the first direction and the second direction are substantially opposing and substantially parallel to the planar busbar in a longitudinal direction of the planar busbar.

In some aspects, the techniques described herein relate to a system, further including: the battery configured to supply the DC power to the inverter; and the motor configured to receive the AC power from the inverter to drive the motor, wherein the system is provided as a vehicle including the inverter, the battery, and the motor.

In some aspects, the techniques described herein relate to a system including a capacitor assembly, the capacitor assembly including: a planar busbar, the planar busbar including a first direct current (DC) busbar and a second DC busbar; one or more first capacitors on a first side of the planar busbar, the one or more first capacitors including a first bobbin with a positive end facing a first direction with respect to the planar busbar; and one or more second capacitors on the first side of the planar busbar, the one or more second capacitors including a second bobbin with a positive end facing a second direction with respect to the planar busbar, wherein the one or more first capacitors are alternately arranged with the one or more second capacitors with respect to the planar busbar.

In some aspects, the techniques described herein relate to a system, wherein the first DC busbar is positive and the second DC busbar is negative.

In some aspects, the techniques described herein relate to a system, wherein the one or more first capacitors and the one or more second capacitors are alternately arranged in a single row or wherein the one or more first capacitors and the one or more second capacitors are alternately arranged in each row of two or more rows.

In some aspects, the techniques described herein relate to a system, wherein the first DC busbar further includes: a connection opening for the one or more first capacitors or the one or more second capacitors, and a cover to cover the connection opening.

In some aspects, the techniques described herein relate to a system including: a capacitor assembly, including: a first capacitor, the first capacitor including a first bobbin with a positive end, wherein the positive end of the first bobbin faces a first direction; and a second capacitor, the second capacitor including a second bobbin with a positive end, wherein the positive end of the second bobbin faces a second direction, wherein the first capacitor is alternately arranged with the second capacitor relative to planar busbar, wherein the planar busbar includes a first direct current (DC) busbar and a second DC busbar, wherein the first DC busbar includes an inner surface and an outer surface, and the second DC busbar includes an inner surface and an outer surface, and wherein the inner surface of the first DC busbar faces the inner surface of the second DC busbar so that at least a portion of the first DC busbar overlaps the second DC busbar.

In some aspects, the techniques described herein relate to a system, wherein first DC busbar is positive and the second DC busbar is negative.

In some aspects, the techniques described herein relate to a system, wherein the first capacitor and the second capacitor are alternately arranged in a single row or wherein the first capacitor and the second capacitor are alternately arranged in each row of two or more rows, so that each of the two or more rows includes a same arrangement of the first capacitor and the second capacitor.

In some aspects, the techniques described herein relate to a system, wherein the first DC busbar further includes a connection opening for the first capacitor or the second capacitor, and a cover to cover the connection opening.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a combined inverter and converter, according to one or more embodiments.
FIG. 2 depicts an electrical power schematic of an inverter in a connected system, according to one or more embodiments.
FIG. 3 depicts a power module and a heat sink assembly for a combined inverter and converter, according to one or more embodiments.
FIG. 4A depicts a polypropylene film capacitor including an axial bobbin, according to one or more embodiments.
FIG. 4B depicts a polypropylene film capacitor including axial bobbins, according to one or more embodiments.
FIG. 5 depicts a side view of a capacitor assembly with a planar busbar, according to one or more embodiments.
FIG. 6 depicts an isometric view of a capacitor assembly with a planar busbar, according to one or more embodiments.
FIG. 7A depicts a single row capacitor assembly with a planar busbar, according to one or more embodiments.
FIG. 7B depicts a double row capacitor assembly with a planar busbar, according to one or more embodiments.
FIG. 8 depicts a planar busbar assembly, according to one or more embodiments.
FIG. 9 depicts current flow paths in the capacitor assembly, according to one or more embodiments.
FIG. 10 depicts an overlap of a cover at an external connection of the capacitor, according to one or more embodiments.
FIG. 11 depicts a top view of a capacitor assembly with a planar busbar, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

Various embodiments of the present disclosure relate generally to a capacitor assembly, and, more particularly, to a bulk capacitor assembly for a power module for an inverter for an electric vehicle.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section

Some DC bulk capacitor designs include a bulk capacitor with polypropylene film capacitor axial bobbins. This axial bobbin structure may lead to a wider gap between the positive and negative busbars connecting parallel bobbins of the bulk capacitors. This wider gap may lead to higher busbar stray inductance and eventually to higher parasitic inductances in the bulk capacitor. The design may include an unparalleled busbar arrangement at the interconnection.

In a traction inverter, a power module may be considered as an important component of the overall system, and the efficiency of the system is directly proportional to the losses occurring in the power module. Addressing the switching losses of the power module can be one of the critical aspects of having an efficient, cost effective, and robust Inverter design. The commutation cell inductance of some systems limits improvement in the switching losses. There are three major components that contribute to overall commutation cell inductance: power module, DC bulk capacitor, and the busbar interconnection. One or more embodiments may provide a DC bulk capacitor design with lower parasitic inductance relative to some designs.

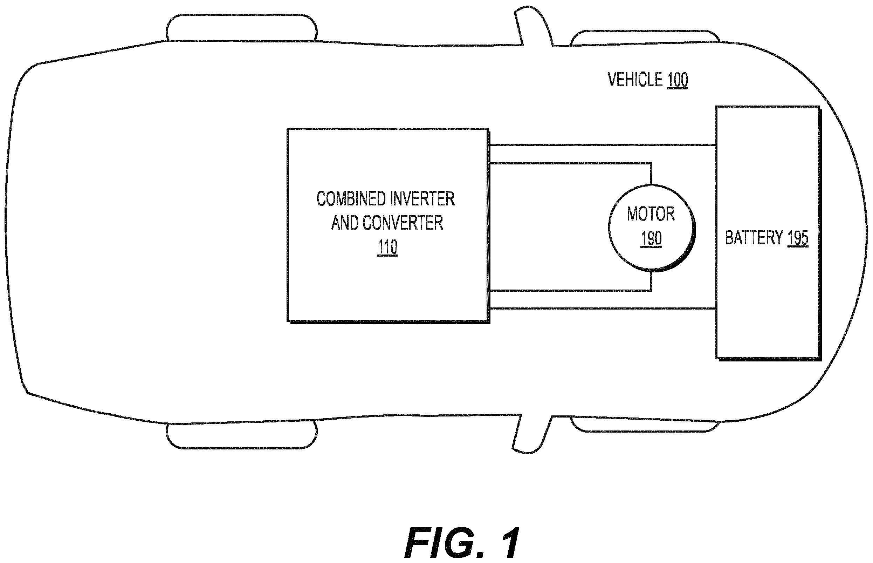

FIG. 1 depicts an exemplary system infrastructure for a vehicle including a combined inverter and converter, according to one or more embodiments. In the context of this disclosure, the combined inverter and converter may be referred to as an inverter. As shown in FIG. 1, electric vehicle 100 may include an inverter 110, a motor 190, and a battery 195. The inverter 110 may include components to receive electrical power from an external source and output electrical power to charge battery 195 of electric vehicle 100. The inverter 110 may convert DC power from battery 195 in electric vehicle 100 to AC power, to drive motor 190 of the electric vehicle 100, for example, but the embodiments are not limited thereto. The inverter 110 may be bidirectional, and may convert DC power to AC power, or convert AC power to DC power, such as during regenerative braking, for example. Inverter 110 may be a three-phase inverter, a single-phase inverter, or a multi-phase inverter.

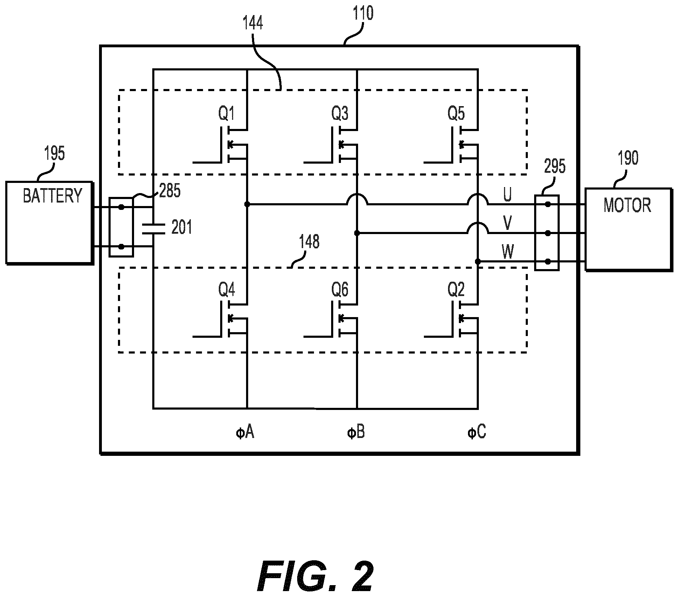

FIG. 2 depicts an electrical power schematic of an inverter in a connected system, according to one or more embodiments. The inverter may be used to convert DC power from a battery in an electric vehicle to AC power, to drive an electric motor of the electric vehicle, for example, but the embodiments are not limited thereto. Additionally, the inverter may be bidirectional, and used to convert DC power to AC power, or to convert AC power to DC power.

As shown in FIG. 2, inverter 110 may be connected to battery 195 (DC power supply) and motor 190. Inverter 110 may include upper phase switches 144 and lower phase switches 148 as components of a power module. A first phase (ΦA) may include switches Q1 and Q4, a second phase (ΦB) may include switches Q3 and Q6, and a third phase (ΦC) may include switches Q5 and Q2, as illustrated in FIG. 2. Upper phase switches 144 may include first phase switch Q1, second phase switch Q3, and third phase switch Q5. Lower phase switches 148 may include first phase switch Q4, second phase switch Q6, and third phase switch Q2. Switches Q1-Q6 may be metal-oxide-semiconductor field-effect transistors (MOSFET), for example, but are not limited thereto. Although FIG. 2 illustrates a three-phase inverter, the disclosure is not limited thereto, and may include single phase or multi-phase or multi-level inverters.

Upper phase switches 144 and lower phase switches 148 may be driven by a PWM signal generated by one or more controllers to convert DC power delivered via the set of input terminals 285 at bulk capacitor 201 to three phase AC power at outputs U, V, and W (correlating with phases A, B, and C, respectively) via the set of output terminals 295 to motor 190. In this disclosure, the bulk capacitor 201 may be referred to as the capacitor components of a bulk capacitor assembly, for which various embodiments are disclosed. Additionally, although FIG. 2 illustrates a three-phase inverter, the disclosure is not limited thereto, and may include single phase or multi-phase or multi-level inverters.

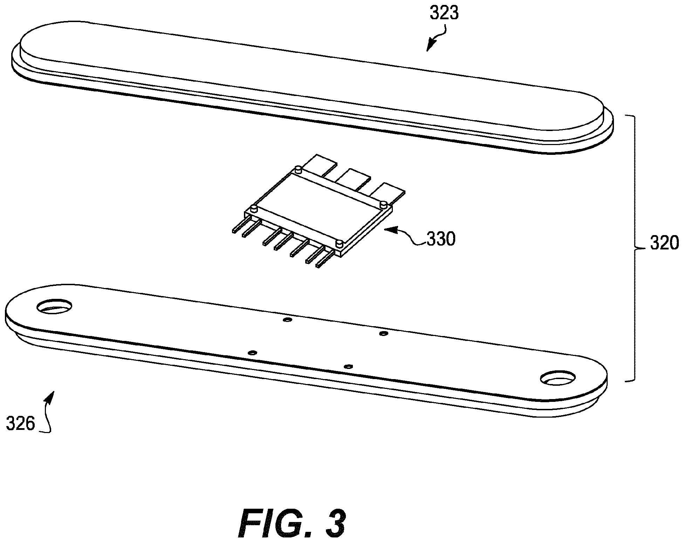

FIG. 3 depicts an exploded view of a power module and a heat sink assembly for an inverter, according to one or more embodiments. For example, power module 330 may be compatible with the inverter 110 shown in FIGS. 1 and 2, and may be used for switching operations for the inverter 110. As depicted, the power module 330 is between a first cooling channel 323 and a second cooling channel 326 of a heat sink assembly 320. The power module 330 may include one or more silicon carbide (SiC)-based power modules that deliver relatively high power densities and efficiencies needed to extend battery range and performance, although other semiconductor switches may be relied upon. The power module 330 may contain circuitry and components configured to convert direct current (DC) from the electric vehicle battery to alternating current (AC) current (and vice versa), which can be utilized by the motor 190, for example, that drives the propulsion system.

The power module 330 may be installed on one or more power board assemblies. The power module 330 may include a combination of transistors, diodes, metal oxide semiconductor field effect transistors (MOSFETs), insulated-gate bipolar transistors (IGBTs), and silicon-controlled rectifiers (SCRs). The power module 330 may include a combination of transistors configured to both a half-bridge and H-bridge configuration, which may allow for the switch ability of the direction of the current through a motor from a single voltage power supply. The power module 330 may also include three or more transistors for inverting applications such as switching direct current (DC) electricity into alternating current (AC) electricity. During operation, the first cooling channel 323 and the second cooling channel 326 may provide cooling for the power module 330, the bulk capacitor 201, and a busbar connectable to the power module 330 and the bulk capacitor 201.

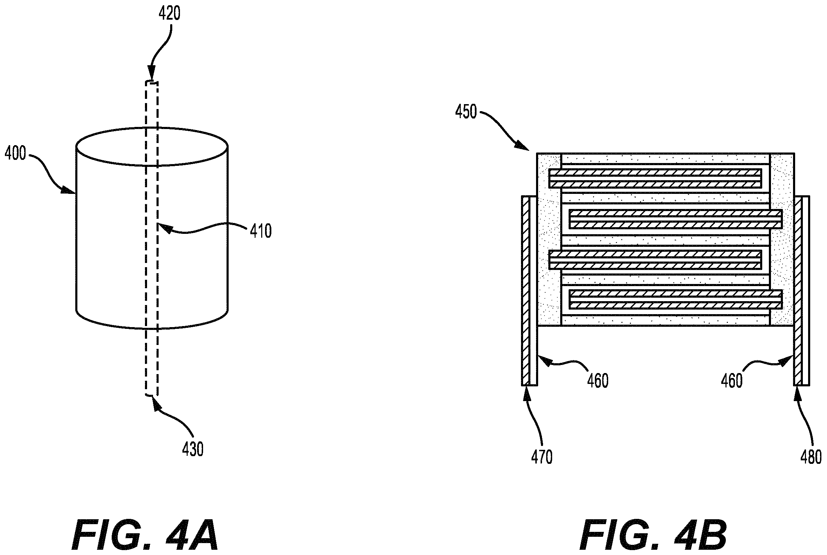

FIG. 4A depicts a polypropylene film capacitor including an axial bobbin, according to one or more embodiments FIG. 4A depicts a capacitor 400. Capacitor 400 may include bobbin 410, which may be axially aligned with respect to capacitor 400 in the longitudinal direction. Bobbin 410 may include a positive end 420 and a negative end 430. For example, a polypropylene film capacitor bobbin may be axial in design for the ease of tapping positive and negative electrodes.

FIG. 4B depicts a polypropylene film capacitor including axial bobbins, according to one or more embodiments FIG. 4B depicts capacitor 450. Capacitor 450 may include bobbin 460. Bobbin 460 may include a positive end 470 and a negative end 480. For example, capacitor 450 may be a polypropylene film capacitor axial bobbin. The polypropylene film capacitor bobbins may be axial in design for the ease of tapping positive and negative electrodes.

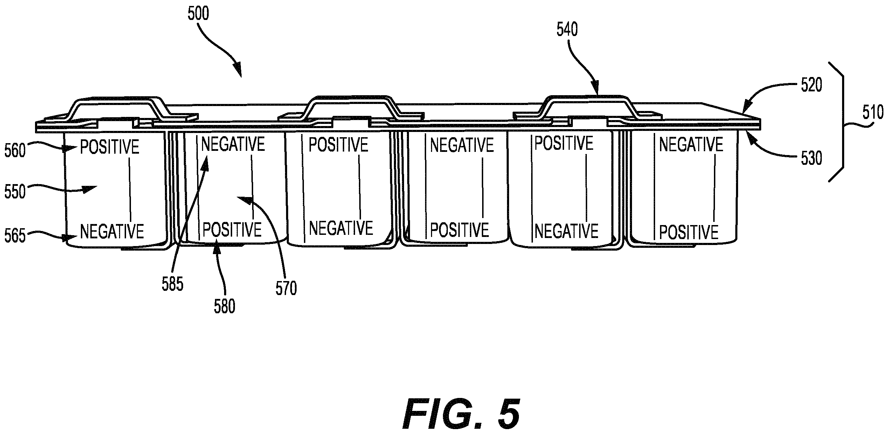

FIG. 5 depicts a side view of a capacitor assembly with a planar busbar, according to one or more embodiments. FIG. 5 depicts capacitor assembly 500 including planar busbar 510, cover 540, first capacitor 550, and second capacitor 570. Planar busbar 510 may include first DC busbar 520 and second DC busbar 530. Although not depicted in FIG. 5, capacitor assembly 500 may include an insulator, such as insulation paper, for example, between first DC busbar 520 and second DC busbar 530. Although FIG. 5 depicts six capacitors, capacitor assembly 500 may include two or more capacitors. The first DC busbar 520 may be positive and the second DC busbar 530 may be negative, for example. The first DC busbar 520 may include an inner surface and an outer surface, and the second DC busbar 530 may include an inner surface and an outer surface. The inner surface of the first DC busbar 520 may face the inner surface of the second DC busbar 530 so that at least a portion of the first DC busbar 520 overlaps the second DC busbar 530. The cover 540 may be connected to the first DC busbar 520.

First capacitor 550 and second capacitor 570 may be similar to capacitor 400 as described in FIG. 4A. First capacitor 550 may include positive end 560 and negative end 565. Second capacitor 570 may include positive end 580 and negative end 585. The positive end 560 of first capacitor 550 may face a first direction. The positive end 580 of second capacitor 570 may face a second direction. The first direction may be a direction toward the planar busbar 510 in a substantially perpendicular direction. The second direction may be a direction away from the planar busbar 510 in a substantially perpendicular direction, and may be opposite to the first direction. The first capacitor 550 and the second capacitor 570 may be alternately arranged with respect to one another. One or more embodiments may resolve the above mentioned challenges and yield lower parasitic inductance of the bulk capacitor.

For example, inverter 110 (See FIG. 1) may include capacitor assembly 500 and power module 330 connectable to the capacitor assembly 500. The capacitor assembly 500 may include planar busbar 510, which may include a first direct current (DC) busbar 520 and a second DC busbar 530. The first DC busbar 520 may be connected to a positive DC charge of a battery (e.g., battery 195), and the second DC busbar 530 may be connected to a negative DC charge of the battery, or vice versa. The planar busbar 510 may be used to transfer electrical power from the battery 195 to a connectable power module 330 and one or more DC-link capacitors (e.g., capacitor 400 or capacitor 450) connected to the planar busbar 510. The first DC busbar 520 and the second DC busbar 530 may be arranged to reduce parasitic inductance of the switching loop of the power module 330.

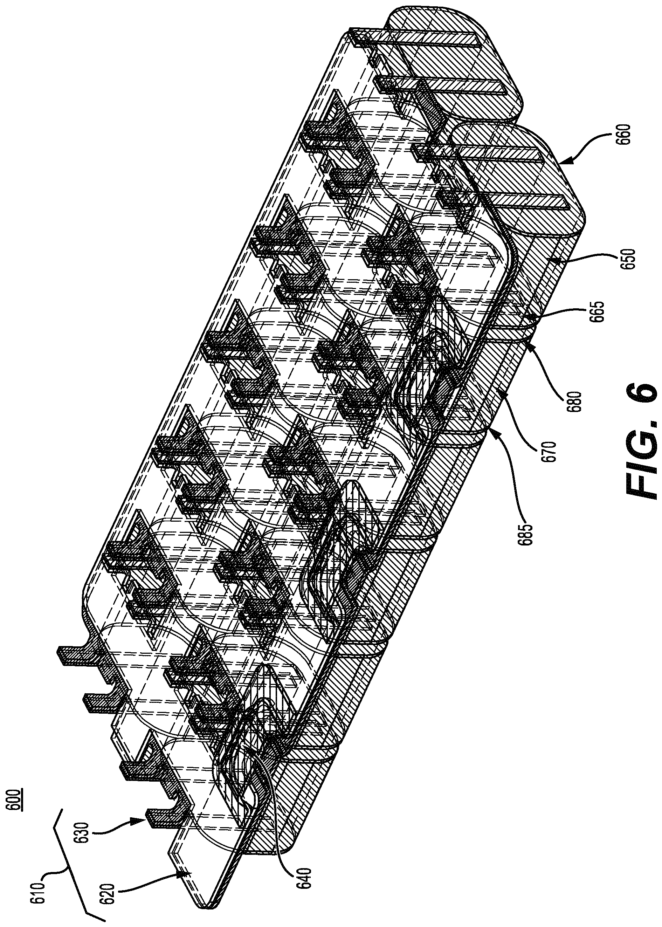

FIG. 6 depicts an isometric view of a capacitor assembly with a planar busbar, according to one or more embodiments. FIG. 6 depicts capacitor assembly 600 including planar busbar 610, cover 640, first capacitor 650, and second capacitor 670. Planar busbar 610 may include first DC busbar 620 and second DC busbar 630. The first DC busbar 620 may be positive and the second DC busbar 630 may be negative. The first DC busbar 620 may include an inner surface and an outer surface and the second DC busbar 630 may include an inner surface and an outer surface. The inner surface of the first DC busbar 620 may face the inner surface of the second DC busbar 630 so that at least a portion of the first DC busbar 620 overlaps the second DC busbar 630. The cover 540 may be connected to the first DC busbar 620. First capacitor 650 may include positive end 660 and negative end 665. Second capacitor 670 may include positive end 680 and negative end 685. The positive end 660 of first capacitor 650 may face a first direction. The negative end 685 of second capacitor 670 may face a second direction. The first direction and the second direction may be substantially opposing and substantially parallel to the planar busbar 610 in the longitudinal direction. The first capacitor 650 and the second capacitor 670 may be alternately arranged with respect to one another. For example, the negative end 665 of first capacitor 650 may face the positive end 680 of second capacitor 670, having opposite ends (e.g., negative end 665 and positive end 680) of the first capacitor 650 and second capacitor 670 that are alternating.

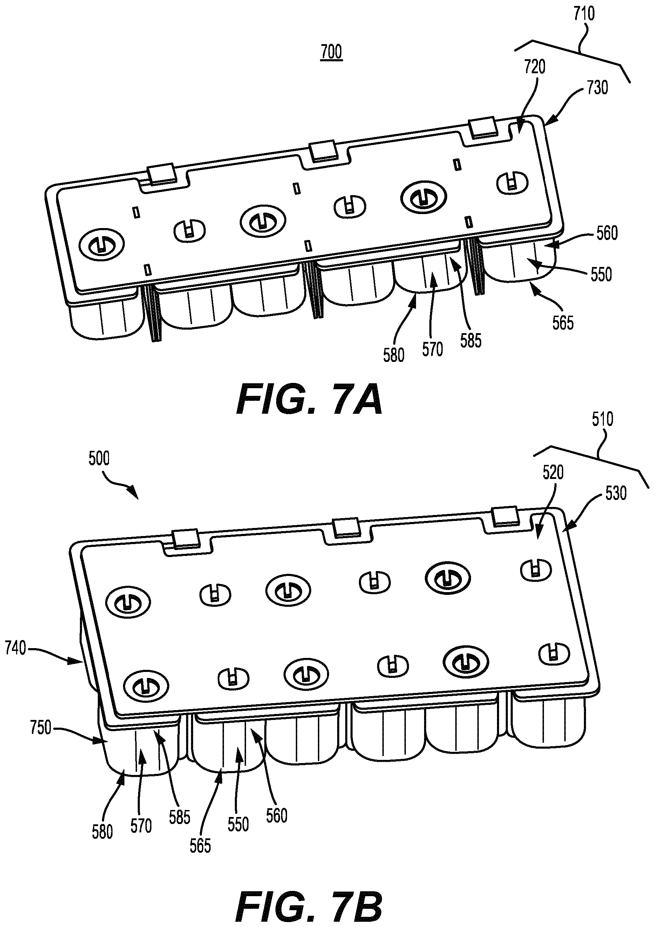

FIG. 7A depicts a single row capacitor assembly with a planar busbar, according to one or more embodiments. FIG. 7A depicts a single row capacitor assembly 700. For example, a single row of capacitors may include two or more capacitors aligned substantially in a straight line. The single row capacitor assembly 700 may include planar busbar 710, first capacitor 550, and second capacitor 570. Planar busbar 710 may include first DC busbar 720 and second DC busbar 730. First capacitor 550 may include positive end 560 and negative end 565. Second capacitor 570 may include positive end 580 and negative end 585. The arrangement of the first capacitor 550 and the second capacitor 570 may be alternating, as similarly described in FIG. 5.

FIG. 7B depicts a double row capacitor assembly with a planar busbar, according to one or more embodiments. FIG. 7B depicts a capacitor assembly 500 including a double row design. For example, a double row of capacitors may include two rows of two or more capacitors aligned substantially in a straight line. The capacitor assembly 500 as a double row design may include planar busbar 510, first capacitor 550, and second capacitor 570. Planar busbar may include first DC busbar 520 and second DC busbar 530. First capacitor 550 may include positive end 560 and negative end 565. Second capacitor 570 may include positive end 580 and negative end 585. The capacitor assembly 500 as a double row design may include a first row of capacitors 740 and a second row of capacitors 750. The first row of capacitors 740 may include first capacitor 550 and second capacitor 570 arranged alternately, similar to that described in FIG. 5. The second row of capacitors 750 may include first capacitor 550 and second capacitor 570 arranged alternately, similar to that described in FIG. 5. For example, the first row of capacitors 740 may have the same arrangement of the second row of capacitors 750.The capacitor assembly 500 as a double row design may be expanded to include more than two rows (e.g., three, four, or five rows of capacitors) as described herein.

One or more embodiments, as described herein, may reduce parasitic inductance more than 80% compared to bulk capacitor designs with the positive and negative busbars having a wider gap between them and/or without alternating capacitors. For example, some capacitor assemblies without alternating capacitors may have a parasitic inductance of 18.83 nH at 1 MHz. One or more embodiments may have a parasitic inductance of 3.62 nH at 1MHz. One or more embodiments may have a parasitic inductance of 3.21 nH at 1 MHz.

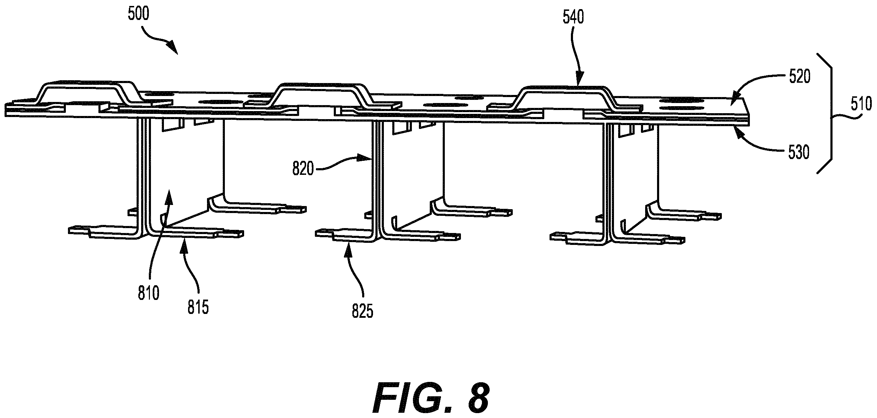

FIG. 8 depicts a planar busbar assembly, according to one or more embodiments. FIG. 8 depicts a planar busbar 510 as similarly described in FIG. 5, but without the first capacitor 550 and second capacitor 570 of the capacitor assembly 500. Planar busbar 510 may include cover 540. Planar busbar 510 may include first DC busbar 520 and second DC busbar 530. First DC busbar 520 may include a first portion 810 and a first connector 815. The first portion 810 may extend in a substantially perpendicular direction from the first DC busbar 520. The first connector 815 may extend in a substantially perpendicular direction from the first portion 810 and substantially in parallel to the first DC busbar 520.

Similarly, the second DC busbar 530 may include a second portion 820 and a second connector 825. The second portion 820 may extend in a substantially perpendicular direction from the second DC busbar 530. The second connector 825 may extend in a substantially perpendicular direction from the second portion 820 and substantially in parallel to the second DC busbar 530. For example, second DC busbar 530, second portion 820, and second connector 825 may be configured to receive first capacitor 550. Likewise, first DC busbar 520, first portion 810, and first connector 815 may be configured to receive second capacitor 570. Arranging the first capacitor 550 and the second capacitor 570 in the planar busbar 510 invertedly allows planar arrangement of the busbar, which, in turn, may reduce the parasitic inductance. The inverted arrangement of bobbin 410 allows the first DC busbar 520 and second DC busbar 530 to overlap and connect to bobbin 410 on the opposite side of the planar busbar 510 as shown. For example, vertical bobbin connections are assembled perpendicular to the respective planar busbars (e.g., first DC busbar 520 and second DC busbar 530), ensure an electrical connection of the individual capacitors to the DC busbar.

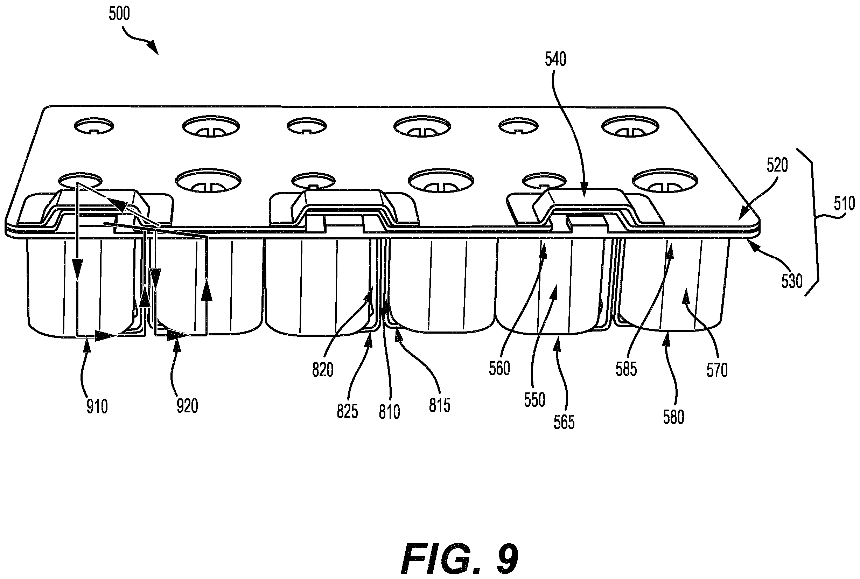

FIG. 9 depicts current flow paths in the capacitor assembly, according to one or more embodiments. FIG. 9 depicts the capacitor assembly 500 as described in FIG. 5, which will not be repeated. Capacitor assembly 500 may include first current flow 910 and second current flow 920. Capacitor assembly 500 may include first capacitor 550 and second capacitor 570. First capacitor may include positive end 560 and negative end 565. Second capacitor 570 may include positive end 580 and negative end 585. As indicated by the arrow direction in the first current flow 910, first current flow 910 may start at the cover 540 and flow through the positive end 560 of the first capacitor 550, in the direction of the negative end 565 of the first capacitor 550. The first current flow 910 may then continue through the second connector 825 and the second portion 820 of the second DC busbar 530.

Similarly, as indicated by the arrow direction in the second current flow 920, second current flow 920 may start in the first portion 810 of the first DC busbar 520, flowing towards the first connector 815 of the first DC busbar 520. The second current flow 920 may continue to the positive end 580 of the second capacitor 570 to the negative end 585 of the second capacitor 570, ending at the cover 540. The first current flow 910 and second current flow 920 may have equal and opposite currents, thereby reducing the inductance. Cover 540 may compensate and reduce the inductance at the interconnection (e.g., interconnect between first DC busbar 520, second DC busbar 530, and first capacitor 550). For example, around 30-40% of inductance comes at the interconnection between the power module 330 and a capacitor (e.g., first capacitor 550 or second capacitor 570).

The DC current flowing through the cover 540 induces a magnetic field that opposes the magnetic field induced, thus reducing the self-induced magnetic field and the self-inductance at cover 540. The magnetic field caused by the current flowing in the respective busbars induces a self and mutual field. The self-induced magnetic field determines the self-inductance of the individual busbars. The mutual magnetic field however, opposes the self-induced field resulting in a reduction of the overall stray inductance. The capacitor assembly 500 enhances the mutual magnetic field resulting in a reduction of the overall stray inductance and the parasitic inductance at higher frequencies.

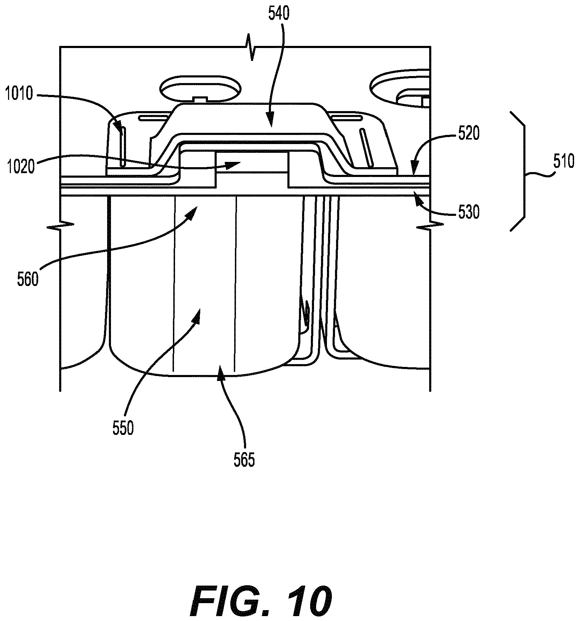

FIG. 10 depicts an overlap of a cover at an external connection of the capacitor, according to one or more embodiments. FIG. 10 depicts capacitor assembly 500 in a magnified manner as shown in FIG. 5, portions of the capacitor assembly 500 will not be repeated for brevity. Cover 540 may be arranged at the first DC busbar 520 and may create a connection opening 1020 between the cover 540, first DC busbar 520, and the second DC busbar 530. The cover 540 may be part of the first DC busbar 520 or an additional attachment. The cover 540 may be assembled to the first DC busbar 520 through a connection 1010 (e.g., laser welding, screwed interconnection, punched busbar, etc.).

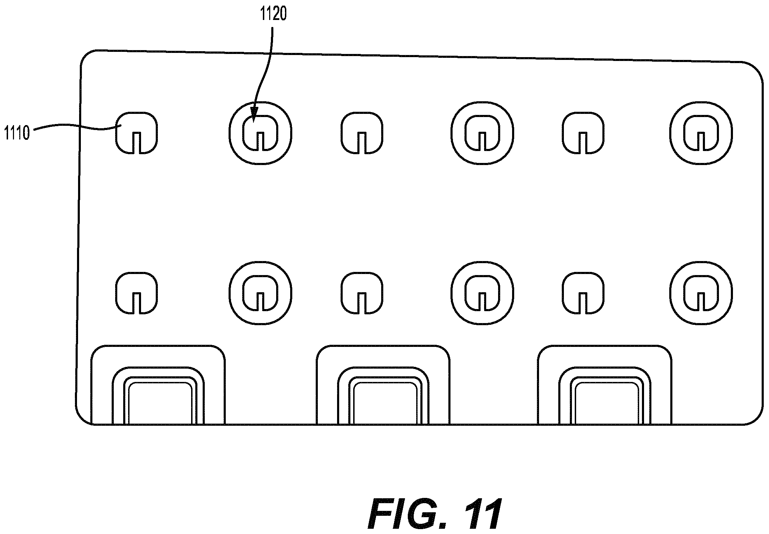

FIG. 11 depicts a top view of a capacitor assembly with a planar busbar, according to one or more embodiments. FIG. 11 depicts a top view of capacitor assembly 500 and may include positive connection 1110 and negative connection 1120. The positive connection 1110 and the negative connection 1120 may be accomplished with metal spray (e.g., zinc) as marked. The positive connection 1110 may be located at the positive end 560 of the first capacitor 550. The negative connection 1120 may be located at the negative end 585 of the second capacitor 570.

One or more embodiments, as described herein, may reduce parasitic inductance more than 80% compared to bulk capacitor designs with the positive and negative busbars having a wider gap between them. The planar busbar 510 including overlapping a first DC busbar 520 and a second DC busbar 530 allow for a connection to bobbin 410 on the opposite sides of the planar busbar 510, thereby reducing the parasitic inductance. Additionally, cover 540 induces a magnetic field that opposes the magnetic field induced, thus reducing the self-induced magnetic field and the self-inductance at cover 540.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A system comprising:
an inverter to convert DC power from a battery to AC power to drive a motor, wherein the inverter includes:
a capacitor assembly, the capacitor assembly including:
a planar busbar, the planar busbar including a first direct current (DC) busbar and a second DC busbar;
one or more first capacitors on a first side of the planar busbar, the one or more first capacitors including a first bobbin with a positive end facing a first direction with respect to the planar busbar; and
one or more second capacitors on the first side of the planar busbar, the one or more second capacitors including a second bobbin with a positive end facing a second direction with respect to the planar busbar,
wherein the one or more first capacitors are alternately arranged with the one or more second capacitors with respect to the planar busbar.

2. The system of claim 1, wherein the one or more first capacitors and the one or more second capacitors are alternately arranged in a single row, or
wherein the one or more first capacitors and the one or more second capacitors are alternately arranged in each row of two or more rows, so that each of the two or more rows includes a same arrangement of the one or more first capacitors and the one or more second capacitors.

3. The system of any one of claims 1 to 2,
wherein the first DC busbar includes an inner surface and an outer surface; wherein the second DC busbar includes an inner surface and an outer surface, and wherein the inner surface of the first DC busbar faces the inner surface of the second DC busbar so that at least a portion of the first DC busbar overlaps the second DC busbar, and/or
wherein the first DC busbar further includes a connection opening for the one or more first capacitors or the one or more second capacitors, and a cover to cover the connection opening.

4. The system of any one of claims 1 to 3, wherein the first bobbin and the second bobbin are arranged in either a horizontal direction or a vertical direction.

5. The system of any one of claims 1 to 4, wherein the one or more first capacitors being alternately arranged with the one or more second capacitors reduces inductance relative to capacitors that are not alternately arranged.

6. The system of any one of claims 1 to 5, wherein the one or more first capacitors include three first capacitors, and
wherein the one or more second capacitors include three second capacitors.

7. The system of any one of claims 1 to 6, wherein the first direction and the second direction are substantially opposite, and/or
wherein the first direction and the second direction are substantially opposing and substantially parallel to the planar busbar in a longitudinal direction of the planar busbar.

8. The system of any one of claims 1 to 7, further comprising:
the battery configured to supply the DC power to the inverter; and
the motor configured to receive the AC power from the inverter to drive the motor, wherein the system is provided as a vehicle including the inverter, the battery, and the motor.

9. A system comprising a capacitor assembly, the capacitor assembly comprising:
a planar busbar, the planar busbar including a first direct current (DC) busbar and a second DC busbar;
one or more first capacitors on a first side of the planar busbar, the one or more first capacitors including a first bobbin with a positive end facing a first direction with respect to the planar busbar; and
one or more second capacitors on the first side of the planar busbar, the one or more second capacitors including a second bobbin with a positive end facing a second direction with respect to the planar busbar,
wherein the one or more first capacitors are alternately arranged with the one or more second capacitors with respect to the planar busbar.

10. The system of claim 9, wherein the one or more first capacitors and the one or more second capacitors are alternately arranged in a single row or wherein the one or more first capacitors and the one or more second capacitors are alternately arranged in each row of two or more rows.

11. The system of any one of claims 9 to 10, wherein the first DC busbar further includes:
a connection opening for the one or more first capacitors or the one or more second capacitors, and
a cover to cover the connection opening.

12. A system comprising:
a capacitor assembly, including:
a first capacitor, the first capacitor including a first bobbin with a positive end, wherein the positive end of the first bobbin faces a first direction; and
a second capacitor, the second capacitor including a second bobbin with a positive end, wherein the positive end of the second bobbin faces a second direction,
wherein the first capacitor is alternately arranged with the second capacitor relative to planar busbar, wherein the planar busbar includes a first direct current (DC) busbar and a second DC busbar,
wherein the first DC busbar includes an inner surface and an outer surface, and the second DC busbar includes an inner surface and an outer surface, and
wherein the inner surface of the first DC busbar faces the inner surface of the second DC busbar so that at least a portion of the first DC busbar overlaps the second DC busbar.

13. The system of claim 12, wherein the first capacitor and the second capacitor are alternately arranged in a single row or wherein the first capacitor and the second capacitor are alternately arranged in each row of two or more rows, so that each of the two or more rows includes a same arrangement of the first capacitor and the second capacitor.

14. The system of claim 12 or 13, wherein the first DC busbar further includes a connection opening for the first capacitor or the second capacitor, and
a cover to cover the connection opening.

15. The system of any one of claims 1 to 14, wherein first DC busbar is positive and the second DC busbar is negative.
